# FASCICULE DE BREVET EUROPEEN

(11) **EP 1 003 254 B1**
(45) Date de publication et mention de la délivrance du brevet: **23.07.2003**
(21) Numéro de dépôt: 99402333.1
(22) Date de dépôt: 23.09.1999
(51) Int. Cl.: H01S 5/026, G02B 6/12

(54) **Composant optique intégré**
Integriert-optisches Bauelement
Integrated optical component

(30) Priorité: 24.09.1998 FR 9811964
(43) Date de publication de la demande: 24.05.2000
(73) Titulaire: ALCATEL, 75008 Paris (FR)
(72) Inventeur: Sillard, Hélène, 94230 Cachan (FR); Brillouet, François, 94230 Cachan (FR); Doussiere, Pierre, 94230 Cachan (FR)
(74) Mandataire: Fournier, Michel Robert Marie

(56) Documents cités:
- YAMAGUCHI M ET AL: "REQUIREMENTS FOR MODULATOR-INTEGRATED DFB LD'S FOR PENALTY-FREE 2.5-GB/S TRANSMISSION" JOURNAL OF LIGHTWAVE TECHNOLOGY, vol. 13, no. 10, 1 octobre 1995 (1995-10-01), pages 1948-1954, XP000596072
- O'BRIEN S ET AL: "OPERATING CHARRACTERISTIC OF A HIGH-POWER MONOLITHICALLY INTEGRATEDFLARED AMPLIFIER MASTER ASCILLATOR POWER AMPLIFIER" IEEE JOURNAL OF QUANTUM ELECTRONICS, vol. 29, no. 6, 1 juin 1993 (1993-06-01), pages 2052-2057, XP000397645

## Description

L'invention concerne un composant optique intégré, et plus particulièrement un composant comportant une première section comprenant un guide d'onde perpendiculaire à une facette de sortie du composant, une terminaison du guide d'onde étant couplée à cette facette, et comprenant une deuxième section en amont de la première susceptible d'être perturbée par le signal réfléchi par ladite facette et guidé par le guide d'onde.

L'invention concerne notamment les composants modulateur-laser et s'applique avantageusement aux modulateurs-lasers optiques intégrés à électroabsorption et aux modulateurs-lasers Mach-Zehnder.

C'est un modulateur-laser à électroabsorption qui est pris dans la suite pour illustrer l'état de la technique et définir le problème technique rencontré ainsi que pour définir l'invention. De tels composants sont utilisés dans des applications telles que les transmissions de signaux optiques longues distances.

Ainsi, l'invention s'applique à tout composant optique intégré ayant une structure présentant les inconvénients cités ci-dessus. Elle s'applique donc en particulier aux modulateurs-lasers, quel que soit le laser, quel que soit le modulateur dès lors que l'on utilise des vitesses de modulation allant de 2,5 Gbits/s à 10 Gbits/s et plus.

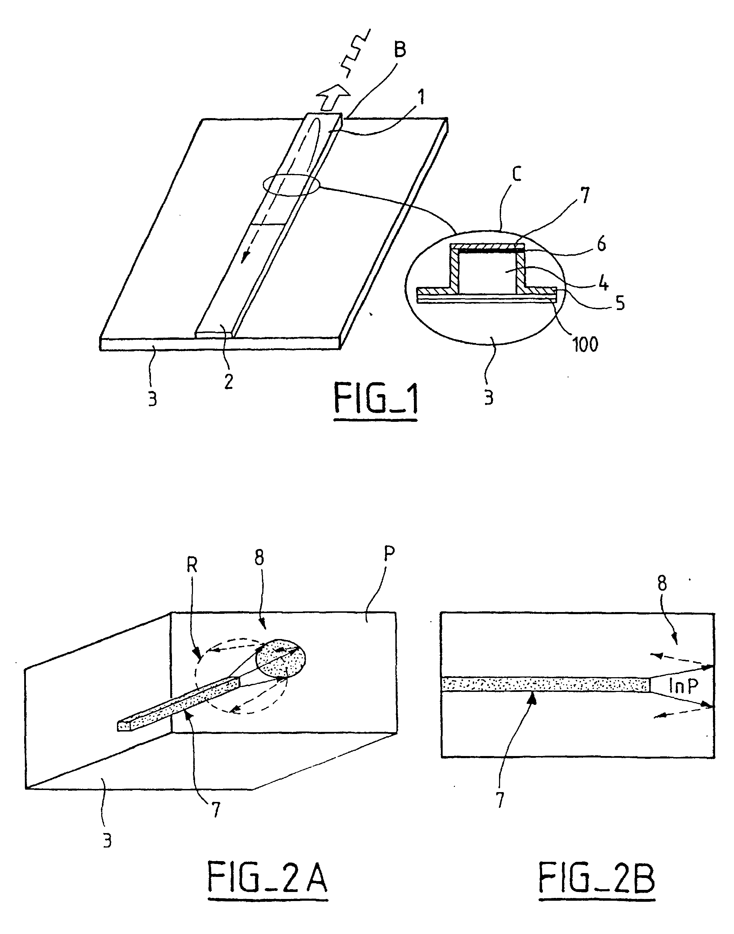

On a représenté sur la figure 1, un schéma illustrant un modulateur-laser à électroabsorption intégré. Ce composant comporte une section modulateur 1, précédée d'une section laser 2.

La section modulateur 1 est montrée en détail sur la coupe C. On peut distinguer ainsi un substrat dopé n en phosphore d'indium InP surmonté d'une couche active guide d'onde 1 en matériau quaternaire InGaAsP. Une cavité 4 dopée p en InP repose sur la couche 100 et est délimitée par une couche de diélectrique 5. Au-dessus de la cavité repose une couche 6 d'un matériau quaternaire tel que de l'InGaAsP. Au-dessus de cette couche est disposée une couche de contact électrique 7.

La section modulateur comprend donc un guide d'onde 100 perpendiculaire à la facette de sortie P du composant (face clivée).

Comme cela a été dit, le problème rencontré avec de tels composants vient du fait qu'il y a des réflexions d'une partie du signal optique, sur la facette de sortie du composant et, que le signal réfléchi, qui repasse dans le guide, peut perturber les sections en amont. En effet, le signal émis par le laser et modulé par la section modulateur se trouve en partie réfléchi par cette facette de sortie et vient exciter le laser à sa fréquence de résonance. La conséquence est que le signal de sortie du composant est très perturbé et cela entraîne une dégradation des performances de la transmission.

Une solution connue permettant de diminuer la quantité de puissance optique réfléchie est, de déposer une couche antireflet sur la facette de sortie du composant. On obtient ainsi typiquement une réflectivité de -30 à -40 dB ce qui est insuffisant pour la plupart des applications. I1 est nécessaire, en particulier pour modulateur-laser, d'avoir -60 dB de réflectivité pour éviter toute excitation du laser avec ce signal qui est à la fréquence de résonance du laser.

Une autre solution connue et illustrée par les figures 2A et 2B, consiste à ajouter une fenêtre 8 en phosphore d'indium InP au bout du guide d'onde 7 enterré dans un substrat 3. A cette fin, la cavité active, c'est-à-dire la couche guidante, est interrompue avant la facette de sortie P. La lumière se diffracte alors dans cette zone d'interruption de guidage du fait justement du faible guidage que présente la fenêtre ainsi réalisée. Une faible quantité R de signal se réfléchit et peut retourner dans le guide et atteindre le laser comme on peut le voir sur les figures 2A et 2B.

On rappelle à ce propos que les procédés de fabrication de composants optiques intégrés font appel aux différentes techniques d'épitaxie pour faire croître des couches sur un substrat InP. Parmi ces techniques on peut citer les techniques d'épitaxie en phase vapeur de composant organométallique dites MOVPE (Metal Organic Vapor Phase Epitaxy) et d'épitaxie à jet moléculaire MBE (Molecular Beam Epitaxy).

Il s'avère que quel que soit la technique d'épitaxie utilisée, la création d'une fenêtre InP, telle que représentée sur les figures 2A et 2B, à l'extrémité du guide d'onde du modulateur, nécessite une étape de lithographie supplémentaire (gravure) avant la reprise finale d'InP.

La réalisation d'une fenêtre InP en extrémité du guide d'onde du modulateur impose donc des étapes supplémentaires qui sont une gravure, puis la croissance de l'InP dans la fenêtre.

Outre ce premier inconvénient relevé avec cette technique, il en existe un autre du fait de l'interface modulateur-fenêtre. En effet, cette interface peut créer des pertes de puissance ou des perturbations sur le signal.

Il existe une autre solution utilisée dans un domaine légèrement différent que celui des modulateurs-lasers, qui est celui des amplificateurs optiques semiconducteurs. En effet, pour éviter qu'une partie du signal guidé et réfléchi ne soit réintroduite dans le guide dans le cas des amplificateurs optiques semiconducteurs, la solution consiste à créer un angle entre le guide d'onde et la facette de sortie. Ainsi, la lumière est réfléchie sous cet angle et, est par conséquent moins guidée.

Cependant, une telle solution n'est pas suffisante pour des structures fortement guidantes, comme c'est le cas dans les composants optiques intégrés comprenant un modulateur-laser, car la lumière reste confinée dans le guide malgré l'angle d'inclinaison.

L'invention a pour objet un composant optique intégré comportant une première section comprenant un guide d'onde perpendiculaire à une facette de sortie du composant, une terminaison du guide d'onde étant couplée à cette facette, et comprenant une deuxième section en amont de la première susceptible d'être perturbée par le signal réfléchi par ladite facette et guidé par le guide d'onde, principalement caractérisé en ce que ladite terminaison du guide comprend une section guidante inclinée par rapport au plan de ladite facette et suivie d'une section non guidante latéralement conduisant à cette facette.

Ainsi, le guide d'onde se prolonge par une section guidante inclinée suivie d'une section non guidante latéralement conduisant à la facette de sortie du composant.

Avantageusement, la section guidante inclinée est de forme courbée.

Selon une autre caractéristique le composant comporte une zone d'isolation pour supprimer les effets de capacité parasite que présente la section non guidante latéralement.

Selon une application de l'invention, la première section est une section modulateur et la deuxième section en amont à la première est une section laser, ledit composant ayant une fonction de modulateur-laser.

D'autres particularités et avantages de la présente invention apparaîtront à la lecture de la description qui est faite ci-après et qui est donnée à titre d'exemple non limitatif et en regard des dessins sur lesquels :
- la figure 1, représente le schéma d'un modulateur-laser intégré à électroabsorption selon l'état de la technique,
- la figures 2A et 2B, représentent le schéma vue en perspective et en coupe d'une section optique intégrée comprenant un guide d'onde avec une fenêtre en InP selon l'état de la technique,
- la figure 3, représente le schéma vue de dessus d'un composant optique intégré selon l'invention, ce composant étant un modulateur-laser,
- les figures 4A, 4B et 4C, représentent respectivement des vues en coupe A-A, B-B et C-C selon la figure 3,
- les figures 5A et 5B, représentent respectivement les courbes i et ii du signal de résonance laser.

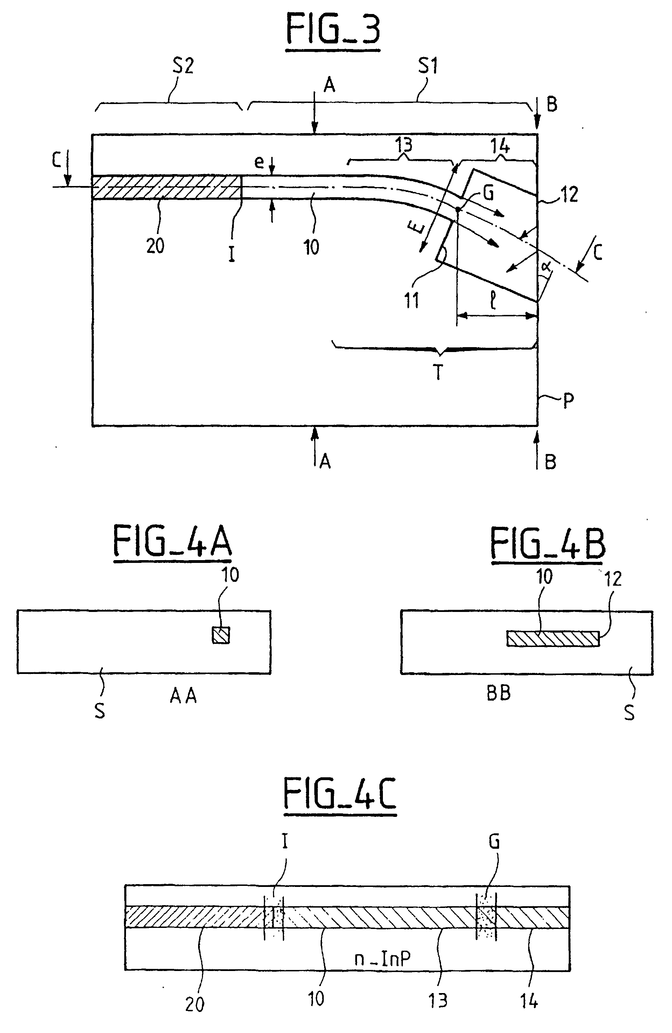

Dans l'exemple qui est donné et qui est illustré par les schémas des figures 3, 4A à 4C, la première section S1 du composant comprend le guide d'onde 10 d'un modulateur-laser, tandis que la deuxième section S2, en amont, comprend le laser 20.

Le guide d'onde 10 en matériau quaternaire tel que de l'InGaAsP, présente d'une manière classique une interface I dopée H+ avec le laser 20 et une sortie 12 dans le plan de la facette de sortie P du composant (plan du clivage).

Le guide d'onde 10 comporte une terminaison T comprenant une section inclinée 13 se terminant par une section 14 non guidante latéralement pour le signal issu de la section étroite 13 du guide. La section non guidante 14 comporte pour cela une largeur E (par exemple de 40 µm) supérieure à la largeur e de la section étroite du guide (qui est par exemple de 3,5 µm). La distance 1 entre la sortie G de la section étroite 13 du guide et la facette de sortie P du composant est d'environ 30 µm. Cette distance peut être réduite à 15 µm.

Afin de supprimer les effets de capacité parasite que présente la section 14 non guidante latéralement, le guide comporte de préférence une zone d'isolation autour de la sortie étroite G, comme on peut le voir sur la figure 4C. En pratique, cette zone d'isolation est obtenue par implantation de protons H+.

Le composant peut être réalisé de manière classique par toute technique d'épitaxie connue dès lors qu'un masque de forme adéquate (angle d'inclinaison par rapport à la facette de sortie et élargissement) est utilisé pour la gravure de la couche active formant le guide que l'on peut voir figure 3.

L'élargissement de la terminaison du guide est donc obtenu sans interruption de la couche active 10 (couche guidante), mais simplement en utilisant un masque de fabrication modifié par rapport aux masques couramment utilisés. En effet, le masque utilisé lors de la gravure de la couche active aura par exemple la forme que l'on peut voir sur la figure 3.

D'autres variantes quant à la forme sont envisageables dès lors qu'elles permettent de supprimer le guidage latéral du signal optique. Dans l'exemple de la figure 3, le bord élargi 11 de la couche active présente un angle de 180° avec les bords latéraux de la section 13. Ce bord 11 pourrait par exemple présenter un angle supérieur à 180°.

Une autre variante peut consister à prendre une largeur E infinie, c'est-à-dire en pratique que le bord 11 de largeur E atteint les deux bords latéraux du composant (bords perpendiculaires à la facette P).

Quant à la section inclinée du guide on a choisi une inclinaison présentant un angle α avec la facette de sortie, d'environ 10°.

De façon pratique l'inclinaison se présente sous la forme d'une courbure.

La combinaison des effets de la présence d'une section non guidée latéralement et d'une section inclinée par rapport à la facette de sortie, permet de dévier la partie du signal réfléchi par cette facette et de le diffracter.

La quantité de signal réfléchi et renvoyé dans la partie guidée plus étroite est grandement diminuée par rapport à l'état de la technique antérieure.

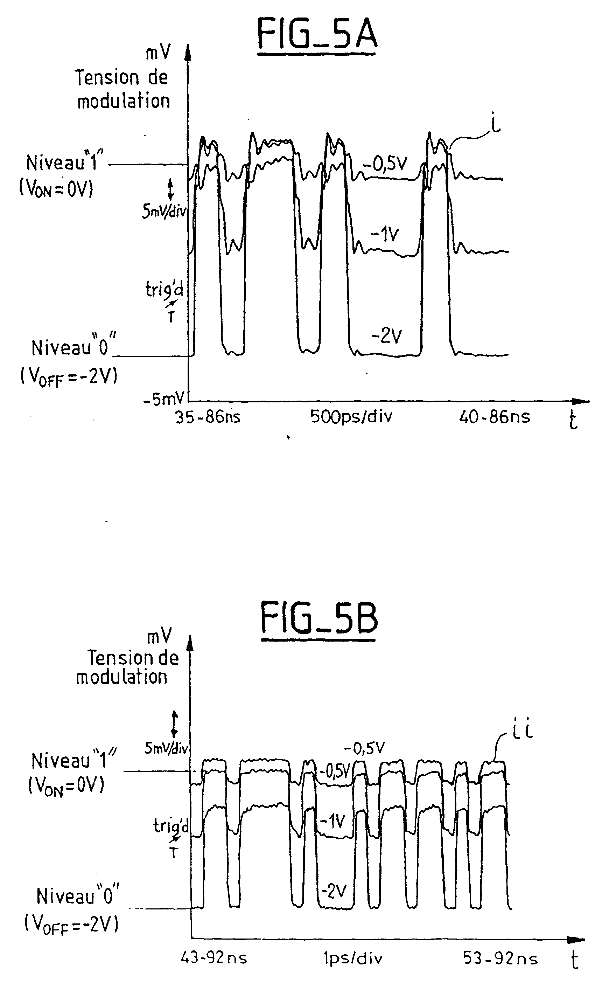

Ces résultats sont illustrés par les courbes i et ii des figures 5A et 5B. Les courbes sont données à titre d'exemple pour une tension de modulation niveau haut "1" V_{ON}= 0v, et une tension niveau bas "0" V_{OFF}= -2v et -1v.

Les courbes i illustrent l'oscillation à la fréquence de résonance du laser provoquée par le signal réfléchi retour pour un composant ayant une structure rectiligne telle que celle représentée sur les figures 2A et 2B.

Les courbes ii illustrent le signal à la fréquence de résonance du laser avec un composant ayant une structure conforme à la présente invention. Cette figure montre qu'il n'y a pas d'oscillation.

## Revendications

1. Composant optique intégré comportant une première section (S1) comprenant un guide d'onde (10) perpendiculaire à une facette de sortie (P) du composant, une terminaison (T) du guide d'onde étant couplée à cette facette, et comprenant une deuxième section (S2) en amont de la première, susceptible d'être perturbée par le signal réfléchi par ladite facette et guidé par le guide d'onde, **caractérisé en ce que** ladite terminaison (T) du guide comprend une section guidante inclinée (13) par rapport an plan de ladite facette et suiivie d'une section non guidante latéralement (14) conduisant à cette facette.

2. Composant optique intégré selon la revendication 1, **caractérisé en ce que** la section guidante inclinée (13) est de forme courbée.

3. Composant optique intégré selon la revendication 1 ou 2, **caractérisé en ce qu'**il comporte une zone d'isolation (G) pour supprimer les effets de capacité parasite que présente la section non guidante latéralement (14).

4. Composant optique intégré selon la revendication 1, **caractérisé en ce que** la première section (S1) est une section modulateur et la deuxième section (S2) en amont à la première est une section laser, ledit composant ayant une fonction de modulateur-laser.

## Patentansprüche

1. Integriertes optisches Bauelement mit einem ersten Abschnitt (S 1), der einen Wellenleiter (10) senkrecht zu einer Austrittsfacette (P) des Bauelements umfasst, wobei ein Abschluss (T) des Wellenleiters an diese Facette gekoppelt ist, und mit einem dem ersten vorgeschalteten zweiten Abschnitt (S2), der in der Lage ist, durch das von der Facette reflektierte und von dem Wellenleiter geführte Signal gestört zu werden, **dadurch gekennzeichnet, dass** der Abschluss (T) des Wellenleiters einen in Bezug auf die Ebene der Facette geneigten leitenden Abschnitt (13) und einen darauf folgenden, zu dieser Facette führenden, seitlich nicht leitenden Abschnitt (14) umfasst.

2. Integriertes optisches Bauelement nach Anspruch 1, **dadurch gekennzeichnet, dass** der geneigte leitende Abschnitt (13) von gekrümmter Form ist.

3. Integriertes optisches Bauelement nach Anspruch 1 oder 2, **dadurch gekennzeichnet, dass** es eine Isolationszone (G) zum Unterdrücken von Störkapazitätseffekten umfasst, die der seitlich nicht leitende Abschnitt (14) aufweist.

4. Integriertes optisches Bauelement nach Anspruch 1, **dadurch gekennzeichnet, dass** der erste Abschnitt (S1) ein Modulatorabschnitt und der dem ersten Abschnitt vorgeschaltete zweite Abschnitt (S2) ein Laserabschnitt ist, und dass das Bauelement eine Modulator-Laser-Funktion hat.

## Claims

1. An integrated optical component comprising a first section (S1) having a waveguide (10) that is perpendicular to an outlet face (P) of the component, a termination (T) of the waveguide being coupled to said face, and further comprising a second section (S2) upstream from the first, capable of being disturbed by the signal reflected by said face and guided by the waveguide, the component being **characterized in that** said waveguide termination (T) comprises a guiding section (13) that is inclined relative to the plane of said face, and that is followed by a laterally non-guiding section (14) leading to said face.

2. An integrated optical component according to claim 1, **characterized in that** the inclined guiding section (13) is curved.

3. An integrated optical component according to claim 1 or claim 2, **characterized in that** it includes an isolation zone (G) so as to eliminate the effects of stray capacitance presented by the laterally non-guiding section (14).

4. An integrated optical component according to claim 1, **characterized in that** the first section (S1) is a modulator section, and the second section (S2), upstream from the first, is a laser section, said component having a modulator-laser function.
